# EUROPEAN PATENT APPLICATION

(11) **EP 1 962 340 A2**
(43) Date of publication of application: **27.08.2008**
(21) Application number: 08007333.1
(22) Date of filing: 09.11.2004
(51) Int. Cl.: H01L 21/76, H01L 21/20

(54) **Method for manufacturing compound material wafers**

(62) Divisional of application: 04292655.0
(71) Applicant: S.O.I. TEC Silicon, 38190 Bernin (FR)
(72) Inventor: Dupont, Frederic, 38100 Grenoble (FR)
(74) Representative: Grünecker, Kinkeldey, Stockmair & Schwanhäusser Anwaltssozietät

(57) **Abstract**

The invention relates to a method for manufacturing compound material wafers, comprising the steps: providing an initial donor substrate (1), forming a predetermined splitting area (4) in the initial donor substrate (1), attaching the initial donor substrate (1) to a handle substrate (2), and detaching the donor substrate (1) at the predetermined splitting area (4), thereby transferring a layer (6) of the initial donor substrate (1) onto the handle substrate (2) to form a compound material wafer (10). To improve the cost effectiveness of the method the method further comprises depositing a layer (12) onto the remainder (9) of the donor substrate after the detaching step to recover at least partially the thickness of the initial donor substrate (1) and reusing the donor substrate (1) with the deposited layer (12) as initial donor substrate (1) in step a). The invention also relates to electronic, opto-electranic or optical components comprising at least a part of the compound material wafer fabricated according to the method.

## Description

The present invention relates to a method for manufacturing compound material wafers according to the preamble of claim 1.

From document US 2003/0153163, a method of transferring a layer of material from a donor substrate to a handle substrate using SmartCut technology is known. The known method comprises a step of forming the donor substrate by bonding a first wafer from which the layer will be transferred to a support substrate. According to US 2003/0153163, the formation of such a donor wafer is advantageous for transferring layers of expensive material as it allows the transfer operation to be repeated several times from the same initial first wafer, unless the full thickness of the first wafer is consumed.

The known method does, however, have the following problems. Due to the fact that the donor substrate is composed of two bonded wafers, its thickness, in particular for the first few transfers, is typically much larger than the thickness of the donor wafers in standard processes, e.g. in the SmartCut technology process for producing silicon on insulator wafers. Accordingly, the equipment used for handling and supporting the donor wafers during the transfer process have to be specially adapted to increased weight and thickness, or the support substrate needs to be especially reduced in thickness. Both possibilities do, however, require adaptive steps which are very costly. In addition, during the manufacturing process, the thickness of the donor wafer is varying, the extent of which depends on the number of transfers performed. As a consequence the processing and handling equipment needs to be especially designed to cope with the varying conditions. Thus the equipment needs to be especially designed and becomes thus even more expensive.

It is therefore the object of the present invention to provide a method for manufacturing compound material wafers which overcomes the problems of the state of the art so that compound material wafers can be fabricated using standard wafer processing equipment.

This object is achieved with the method for manufacturing compound material wafers according to claim 1. Accordingly, the inventive method comprises the steps of: a) providing an initial donor substrate, b) forming a predetermined splitting area in the initial donor substrate, c) attaching the initial donor substrate to a handle substrate, and d) detaching the donor substrate at the predetermined splitting area, thereby transferring a layer on the initial donor substrate onto the handle substrate to form a compound material wafer, and
characterized in e) depositing a layer onto the remainder of the donor substrate after the detaching step to recover at least partially the thickness of the initial donor substrate and f) reusing the donor substrate with the deposited layer as initial donor substrate in step a).

The donor substrate employed in the inventive method is thinner than the one employed in the state of the art process, as it is not bonded to an additional support substrate. As furthermore, due to the deposited layer, the thickness of the donor substrate does not vary much, standard wafer-processing equipment can be employed, such that no time-consuming and expensive adapting or special handling equipment is needed. Thus the inventive process is cheaper to realize than the one of the prior art.

Before reusing the remainder of the donor substrate, an additional reconditioning step could be performed on the surface of the remainder of the donor substrate which is going to be attached to the handle substrate. This reconditioning could for example be performed by polishing.

Advantageously steps a) to d) are repeated at least two times before carrying out the depositing step e), wherein in a repeated step a) the detached remainder of the donor substrate is reused as initial donor substrate. Repeating parts of the process prior to depositing further helps in optimizing the process, as less steps corresponds to faster and therefore less expensive production method.

Preferably, steps a) to d) are repeated until the initial donor substrate reaches a predetermined minimal thickness. The upper limit for the number repetitions can be either determined by the thickness of the remainder of the donor substrate for which the properties of the substrate, e.g. the mechanical strength, start to degrade, or be related to the properties of the handling equipment which may require a certain minimum thickness to function properly. Due to the repetitions the overall process can be further optimized while at the same time the quality of the compound material wafers as well as the production yield can be kept high.

According to one preferred embodiment, the layer in step e) can be deposited homoepitaxially. The inventive method is especially advantageous for expensive donor substrates, which are usually of a crystalline material. By homoepitaxially regrowing the donor substrate up to its initial thickness or beyond, the process becomes in fact independent of the availability of donor substrates, as the number of times the donor substrate can be reused exceeds the number of times necessary to consume the thickness of the initial donor substrate. In this context, homoepitaxial means that the deposited layer is of the same material with the same crystallographic properties as the material of the initial donor substrate.

Preferably in step e) the homoepitaxial layer can be provided using a metal organic chemical vapor deposition (MOCVD) method, a hybrid vapor phase epitaxy (HVPE) method or a molecular beam epitaxy (MBE) method, to thereby achieve an improved dislocation density, in particular a dislocation density of less than 1 x 10⁷ per cm², in particular less than 1 x 10⁶ per cm² in the homoepitaxial layer compared to the dislocation density in the initial donor substrate. Dislocations tend to block at a certain level during growth, so that additional grown material will present a lower dislocation density. Thus, the quality of the donor substrate material becomes better, so that the transferred layer will also become better in quality than compared to transferred layers which are achieved by standard donor substrates available on the market.

Advantageously step e) can comprise providing the layer on the surface side of the remainder of the donor substrate which is opposite to the surface side at which detachment occurred. When polar donor substrates are used, meaning that the two main surfaces of the substrate have different properties, it is usually the case that epitaxial growth can be well controlled on one surface whereas, for the other surface, this is not the case. The free surface of the transferred layer of the material compound wafer should correspond to surface for which the polarity allows controlled growth of further epitaxial layers which may be needed in further process steps to create micro electronic or opto-electronic elements. As a consequence the surface of the transferred layer that is attached to the surface of the handle substrate will have the second polarity. Therefore the surface of the remainder of the donor substrate at which detachment occurred has the polarity for which epitaxial growth is not so well controlled. Therefore the deposition of the additional layer is preferable carried out at the opposite side, where thus controlled homoepitaxial growth can occur, so that the quality of the deposited layer is good.

Preferably prior to carrying out step e), the surface side at which detachment occurred can be provided with a protective layer, in particular using an oxide and/or nitride layer. This protective layer advantageously protects the remainder of the donor substrate from contamination like metals or particles, in particular during the deposition of the layer on the opposite side of the wafer. This protection serves to improve or maintain the quality of the compound material wafer.

Advantageously, the method can comprise a further step of removing the protective layer prior to reusing the donor substrate with the layer as an initial donor substrate. Eventually the removing step can be accompanied by an additional polishing or cleaning step. Thus, when attaching the protective surface side of the donor substrate to a handle substrate, the surface properties of the reused donor substrate are such that bonding can be achieved and wherein the surface quality at which bonding is achieved is high.

Advantageously, the surface side of the remainder of the donor substrate on which the layer is to be provided in step e) can be polished and/or cleaned prior to the deposition of the layer. This will improve the quality of the deposited layer, which is of particular interest when the deposited layer is a homoepitaxial layer, which in turn will be used as a transfer layer during a later stage in the fabrication process.

The method is particularly advantageous for the donor substrate being one of the group of gallium nitride (GaN), silicon carbide (SiC), germanium (Ge), aluminum nitride (AIN) or diamond. These substrates play an important role in electronic applications and it is difficult to obtain good quality at reasonable prices. By using the above-described method with this kind of materials it becomes possible to achieve good quality material compound wafers that are cheaper compared to the bulk material itself.

Preferably the handle substrate used is a monocrystalline or polycrystalline material, in particular one of the group of gallium arsenide (GaAs), zinc oxide (ZnO), silicon carbide (SiC) or aluminum nitride (AIN). It is preferable to use handle substrates that have a coefficient of thermal expansion similar to the donor substrate material, with further improves the quality of the material compound wafer. For further cost reduction, polycrystalline material can be advantageously employed compare to monocrystalline material. In the more general case, the handle substrate could also be formed of silicon (Si), glass or a ceramic material.

According to a variant, the handle substrate can be provided with an insulating layer, in particular, silicon dioxide (SiO₂) or silicon nitride (Si₃N₄), or be provided with a conducting layer on the surface which is going to be attached to the donor substrate. Such additional layers further increase the amount of different compound material wafers suitable for various applications in microelectronics or opto-electronics.

The invention also relates to electronic, opto-electronic or optical components comprising at least a part of the compound material wafer fabricated according to the above-described method.

Specific embodiments of the present invention shall become more apparent from the following detailed description with reference to the accompanying drawing in which
Fig. 1 schematically shows the steps for carrying out the method for manufacturing compound material wafers according to an embodiment of the invention,
Figs. 2a and 2b schematically show donor substrates with two different kinds of deposited layers,
Fig. 3 schematically shows the steps for carrying out the method for fabricating compound material wafers according to a second embodiment of the invention.

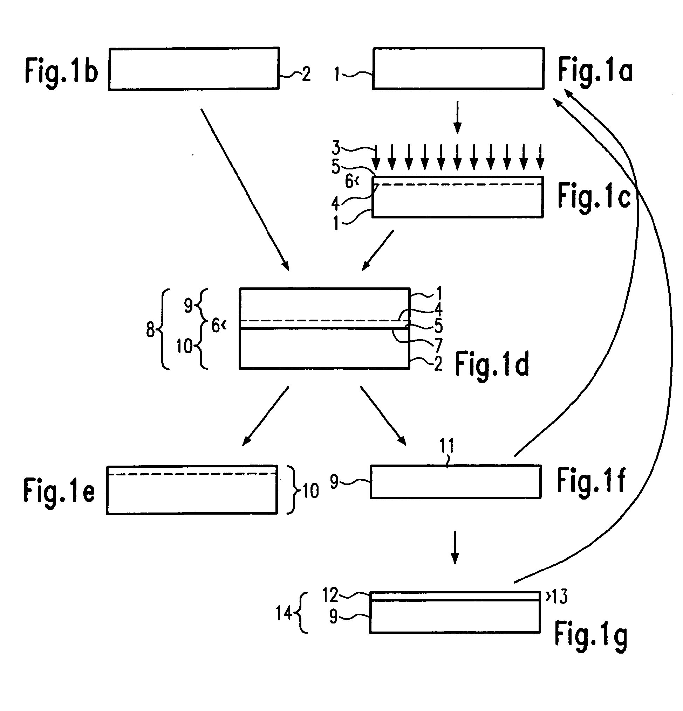

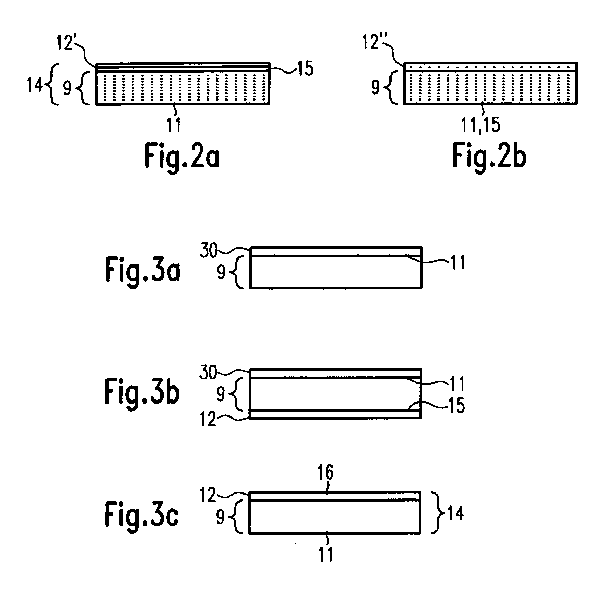

The embodiments of the inventive method for manufacturing compound material wafers according to Fig. 1 and 2 are based on SmartCut technology. However, any other process suitable to manufacture a compound material wafer and comprising predetermined splitting areas are also applicable.

Fig. 1a illustrates an initial donor substrate 1, like, for example, a wafer of a predetermined size and, in particular, out of a crystalline material like gallium nitride (GaN), silicon carbide (SiC), germanium (Ge), aluminum nitride (AIN) or diamond. These materials play an importance role in micro electronic and opto-electronic applications, but are difficult to manufacture and therefore relatively expensive. That is why according to this invention the initial donor substrate 1 is used to transfer a thin layer of the donor onto a handle substrate 2, shown in Fig. 1b, being a wafer of a cheaper material. Preferably the handle substrate 2 has a similar coefficient of thermal expansion than the material of the initial donor substrate 1. In the case of GaN, for example, suitable materials would be gallium arsenide (GaAs), zinc oxide (ZnO), silicon carbide (SiC) or aluminum nitride (AIN). For these wafers, the material does not necessarily have to be monocrystalline, but also polycrystalline type wafers can be used.

In a variant, prior to the bonding step illustrated in Fig. 1d, an insulating layer, in particular silicon dioxide (SiO₂) or silicon nitride (Si₃N₄) or a conducting layer can be provided on the surface 7 of the handle substrate 2 at which bonding with the donor substrate 1 will occur.

To be able to transfer a layer of the donor substrate 1 onto the handle substrate 2 it is necessary to create a predetermined splitting area in the initial donor substrate 1. Following the SmartCut technology, illustrated in Fig. 1c, this is achieved by implanting atomic species 3, like for example hydrogen ions or other inert gases, with a predetermined dose and energy, such that due to the implanted atomic species 3 a predetermined splitting area 4 is created in the donor substrate 1. The predetermined splitting area 4 is substantially in parallel to the main surface 5 of the donor substrate 1. Between this main surface 5 and the predetermined splitting area 4, a layer 6 is created which during the following process steps will be transferred onto the handle substrate 2.

Fig. 1d illustrates the next step in the process which consists in attaching the initial donor substrate 1 to the handle substrate 2, by bonding the main surface 5 of the donor substrate 1 to one of the main surfaces 7 of the handle substrate. Prior to bonding the surfaces 5, 7 to be contacted have been prepared so that they can be bonded together.

The donor handle compound 8 is then placed into a furnace (not shown) and heated such that the predetermined splitting area 4 is fragilized which finally leads to a detachment of the remainder 9 of the donor substrate 1 from the compound material wafer 10 being composed out of the handle substrate 2 and the transferred layer 6. Instead of providing thermal energy, the fragilization and detachment may also be achieved by providing additional energy in any form, for instance mechanical energy or a combination of thermal and mechanical energy.

The two products, compound material wafer 10 and remainder 9 of the initial substrate are illustrated in Figs. 1e and 1f. Prior to further processing the material compound wafer 10 may receive a final surface treatment, like e.g. polishing and/or cleaning.

The remainder 9 of the donor substrate (Fig. 1f) may now be reused as initial donor substrate 1 and the process restarts with the step illustrated in Fig. 1a or a layer may be deposited which will be described further below in respect with Fig. 1f. Eventually prior to the reuse, the surface 11 at which the detachment occurred may be reconditioned by, for example, polishing prior to the following implantation and bonding steps shown in Figs. 1c and 1d. This repeatable reuse of the remainder 9 of the donor substrate can be performed several times, for instance up to 10 times if it is considered that each layer transfer and reconditioning leads to a removal of about 5 µm thickness and that a removal of about 50 µm from the bulk of a donor substrate 1 leads to a fragilization of the substrate which would be too much for keeping the quality of the transferred layers 6 suitable for the application.

Thus, once the minimum thickness of the remainder 9 of the donor substrate or that the minimum thickness necessary for the handling equipment to guarantee the good functioning of the process, has been achieved, the method proceeds with the step illustrated in Fig. 1g, namely that a layer 12 is deposited onto the remainder 9 of the donor substrate. The thickness 13 of the deposited layer 12 allows to recover at least partially the thickness of the initial donor substrate 1, so that this reconditioned donor substrate 14 can be reused as the initial donor substrate 1, illustrated in Fig. 1a.

According to one variant, illustrated in Fig. 2a, the deposited layer 12' is made out of a material which can be rapidly deposited onto the surface side 15 of the remainder 9 of the substrate which is opposite to the surface 11 on which the detachment occurred. Thus, according to this variant, emphasis is put on the fact that the remainder 9 of the donor substrate is rapidly brought back to a thickness sufficient for the further reuse. As such it is not necessary that the material of the deposited layer 12' is the same as the material of the initial donor substrate 9. If, however, the material of layer 12' has been chosen to be the same as the one of the donor substrate 9 the growth conditions can been chosen such that the growth speed is optimized. In this case the crystalline quality of the additional layer 12' may not be sufficient for a later use as a transfer layer 6. In this case, once the initial donor substrate 1 has been completely consumed, a new donor substrate wafer 1 needs to be introduced in the process.

According to the variant, illustrate in Fig. 2b, the deposited layer 12" is made out of the same material as the remainder 9 of the donor substrate and, in addition, is homoepitaxially grown, such that the crystalline quality of the layer 12" is at least comparable to the one of the remainder 9 of substrate. Layer 12" can be either deposited on surface 11 or on surface 15. In this case, no new donor substrate 1 needs to be introduced in the process, as also the deposited layer 12" can later on serve as a transfer layer 6. Using MOCVD, HVPE or MBE methods it is even possible to achieve layers 12" which are better in crystalline quality than the initial quality of the donor substrate 1. In particular, it is possible to achieve dislocation densities of less than 1 x 10⁷ per cm² when the disclocation density of the initial donor substrate is typically larger than this value.

In the case of Fig. 2a the attachment between the reconditioned donor substrate 14 and the handle substrate 2 will occur via surface 11. In the case of Fig. 2b attachment can occur via both surfaces.

Fig. 3 illustrates a second embodiment of the inventive manufacturing method in which the step illustrated in Fig. 1g is replaced by the process steps illustrated in Figs. 3a to 3c. Elements and features having the same reference numerals as employed in Fig. 1 are corresponding and are therefore not explained in detail again, but their description is incorporated herewith by reference.

According to the manufacturing step illustrated in Fig. 3a a protective layer 30 is deposited on the surface 11 of the remainder 9 of the donor substrate at which the dettachment occurred, to protect surface 11 against contamination or mechanical damage. Suitable protecting materials comprise silicon dioxide or silicon nitride (SiO₂, Si₃N₄).

In the step illustrated in Fig. 3b, the layer 12 is deposited on the opposite surface side 15 of the remainder of the donor substrate 9. This step is identical to the one illustrated and described with respect to Fig. 1g of the first embodiment.

The following step illustrated in Fig. 3c consists of removing the protective layer 30. The reconditioned donor substrate 14, comprising the remainder 9 of the donor substrate and the deposited layer 12 is then reused as initial donor substrate 1. Eventually the removing of the protective layer 30 can be accompanied by an additional polishing and/or cleaning step of surface 11.

According to a further variant after the growth of layer 12 the surface 16 of the additional layer 16 could be provided with a further protective film to protect this surface of the reconditioned donor substrate 14 during the process steps illustrated in Figs. 1a to 1f.

In the following, the application of the inventive manufacturing method will be explained in detail using the example of a compound wafer comprising a transferred GaN layer. Variants which will not be explained again in the following can nevertheless also be applied at any time and are therefore incorporated by reference.

As initial donor substrate 1 a GaN wafer is supplied, and as handle substrate a GaAS wafer of the same diameter is provided as handle substrate 2.

GaN wafers, in their hexagonal structure, have polar main surfaces, meaning that one surface presents Ga atoms (in the following Ga surface), whereas the other surface presents N atoms (in the following N surface). For the transfer of GaN layers it is usually requested to have the Ga surface as the free surface, thus the N surface of the GaN wafer will bond with the handle substrate 2.

Prior to starting the transfer process the N surface of the GaN donor substrate 1 is polished to remove defective layers usually extending over 2 to 4 µm. This defective layers arise form the buffer layer that has been used for the initial formation of the GaN wafer. This can be done by polishing. However other GaN substrates exist that do not have this inconvenient, like e.g. disclosed in WO 03/017357.

The predetermined splitting area 4 is achieved by ion implantation of H ions (process step as illustrated in Fig. 1c) with a dose in a range of about 1*10¹⁵ at/cm² to 1*10¹⁸ at/cm² and an energy in a range of about 20 keV to 200 keV. With a dose of 5*10¹⁶ at/cm² and an energy of 60 keV the predetermined splitting area is in depth of about a few 100 nm from the surface. Prior to implantation a protective layer could be deposited (SiO₂ or Si₃N₄) to avoid a contamination of the GaN layer and/or in order to form a layer that may assist in bonding to the handle substrate 2.

According to step 1 d the GaN substrate 1 and the handle substrate GaAs 2 are bonded. To achieve bonding the surfaces 5, which represents a N surface, and 7 which will contact each other, must be flat on an atomic scale. This is achieved by appropriate polishing of the N surface of the GaN substrate, so that a rugosity of below 0.3 nm RMS for a scan with a size of 5 µm times 5 µm is achieved.

The donor handle compound 8 is then brought into a furnace and receives a heat treatment over about 1 to 6 hours in a temperature situated within a range of about 200°C to about 500°C to weaken the predetermined splitting area until detachment occurs. Alternatively mechanical energy, like the introduction of a blade, or a mix of thermal and mechanical energy can be employed.

After carrying out the transfer from the initial GaN donor substrate 1, e.g. 2 to 5 times, the remainder 9 of the GaN donor substrate is introduced into an epitaxial reactor, where a layer 12 of GaN is epitaxially deposited on the Ga surface 15 using MOCVD, HVPE or MBE methods. The growth temperature is within about 700°C to 1100°C. Depending on the application the deposited layer 12 can, in addition, be doped. The total thickness deposited could be up to a few 100 µm, ideally it could be selected to recover the initial thickness of the initial GaN donor substrate 1. Depending on the growth conditions GaN layers are achieved with better or worse dislocation density than in the starting substrate.

Of course it is possible to provide/remove adequate protective layers to the Ga or N surfaces depending on which surface is currently needed. In addition to recondition the Ga surface an epi ready step can be performed using an appropriate CMP and/or cleaning step.

Once the GaN layer 12 deposited a further SmartCut cycle can be performed repeating the above mentioned steps.

## Claims

1. GaN donor substrate with a N surface and a Ga surface, **characterised in that** on the Ga surface a layer (12) is provided.

2. GaN donor substrate according to claim 1, wherein the layer (12) is GaN.

3. GaN donor substrate according to claims 1 or 2, wherein the layer (12) has a thickness of up to 100 µm.

4. GaN donor substrate according to one of claims 1 - 3, wherein the dislocation density in the layer (12) is less than 1 x 10⁷ per cm², more in particular less than 1 x 10⁶ cm².

5. GaN donor substrate according to one of claims 1 - 4, wherein the layer (12) is doped.

6. GaN donor substrate according to one of claims 1 - 5, wherein the surface roughness of the N surface (5) is below 0.3 nm RMS for a scan with a size of 5 µm times 5 µm.

7. GaN donor substrate according to one of claims 1 - 6, bonded with its N surface on to a support substrate.

8. GaN donor substrate, wherein the crystalline quality of the layer (12) is lower than the one of the remainder (9) of the donor substrate.

9. Reconditioned donor substrate comprising a remainder (9) of an initial donor substrate (1) having one surface side (11) at which detachment of a layer occurred and an opposite surface side (15) on which a layer (12) is provided.

10. Reconditioned donor substrate according to claim 9, wherein the layer (12) is a homoepitaxial layer.

11. Reconditioned donor substrate according to claim 9, wherein the layer (12) is of the same material as the remainder (9), but wherein the crystalline quality of the layer (12) is lower than the one of the remainder (9).

12. Reconditioned donor substrate according to one of claims 9 to 11, wherein the layer (12) has a thickness of up to 100µm.

13. Reconditioned donor substrate according to one of claims 9 to 12, wherein the dislocation density in the layer (12) is better than in the remainder, in particular less than 1 x 10⁷ per cm², more in particular less than 1 x 10⁶ per cm².

14. Reconditioned donor substrate according to one of claims 9 to 13, further comprising a protective layer (30) on the surface side (11) of the remainder (9) of the initial donor substrate at which detachment occurred.

15. Method for preparing a reconditioned donor substrate comprising providing a remainder (9) of an initial donor substrate (1) having one surface side (11) at which detachment of a layer occurred and providing a layer (12) on the opposite surface side (15).
